# EUROPEAN PATENT APPLICATION

(11) **EP 0 736 903 A2**
(43) Date of publication of application: **09.10.1996**
(21) Application number: 96105469.9
(22) Date of filing: 04.04.1996
(51) Int. Cl.: H01L 25/065

(54) **Three-dimensional multi-chip module having stacked semiconductor chips and process of fabrication thereof**

(30) Priority: 07.04.1995 JP 82885/95
(71) Applicant: NEC CORPORATION, Tokyo (JP)
(72) Inventor: Senba, Naoji, c/o NEC Corporation, Tokyo (JP); Shimada, Yuzo, c/o NEC Corporation, Tokyo (JP)
(74) Representative: VOSSIUS & PARTNER

(57) **Abstract**

A plurality of semiconductor chips (21a-21d) are sequentially bonded to one another so as to form a stacked semiconductor chip structure (21), and the stacked semiconductor chip structure is accommodated in a cavity (22a) formed in an insulating carrier (22); while the semiconductor chips (21a-21d) are being sequentially stacked, a conductive pattern (22c) formed on the bottom surface of the insulating carrier is connected to electrodes (21h/21i) on each of the semiconductor chips through bonding wires (23), and the three-dimensional multi-chip module is only slightly higher than the stacked semiconductor chip structure.

## Description

This invention relates to a three-dimensional multi-chip module and, more particularly, to a three-dimensional multi-chip module having stacked semiconductor chips.

A typical example of the three-dimensional multi-chip module is disclosed in Japanese Patent Publication of Unexamined Application No. 61-101067, and figure 1 illustrates the prior art three-dimensional multi-chip module.

The prior art three-dimensional multi-chip module largely comprises chip carriers 1a, 1b, 1c and 1d and semiconductor chips 2a, 2b, 2c and 2d respectively mounted on the chip carriers 1a to 1d. Conductive patterns 3a, 3b, 3c and 3d and ceramic plates 4a, 4b, 4c and 4d form the chip carriers 1a to 1d, and the pads on the semiconductor chips 2a to 2d are respectively connected through bonding wirings 5a, 5b, 5c and 5d to the conductive patterns 3a to 3d. The conductive patterns 4a to 4d are identical in arrangement to one another.

A static random access memory device is fabricated on each of the semiconductor chips 2a to 2d, and an address signal, a data signal and control signals are similarly assigned to the pads on the semiconductor chips 2a to 2d. The bonding wires 5a to 5d similarly connect the pads to the conductive strips of the patterns 3a to 3d, and the address signal, the data signal and the control signals except for the chip enable signal are supplied to and from the corresponding conductive strips of the patterns 3a to 3d. For example, a control signal is assigned to pads 6a, 6b, 6c and 6d of the semiconductor chips 2a to 2d, and the conductive strips 7a, 7b, 7c and 7d are located in corresponding positions in the patterns 3a to 3d.

The semiconductor chips 2a to 2d and the bonding wires 5a to 5d are covered with molding resin 8, and the conductive patterns 3a to 3d are coated with solder 9. The chip carriers 3a to 3d are successively stacked, and the solder 9 is reflowed. The solder 9 fixes the chip carriers 3a to 3d, and the chip carriers 3a to 3d are fabricated into the prior art three-dimensional multi-chip module.

When the chip carriers 3a to 3d are stacked, the corresponding conductive strips such as 7a to 7d are sequentially connected to one another, and propagate the address signal, the data signal and the control signals to and from the static random access memory devices.

Another prior art three-dimensional multi-chip module is disclosed in Japanese Patent Publication of Unexamined Application No. 2-310957. Figure 2 illustrates a semiconductor device serving as a component unit 10 of the prior art multi-chip module, and figure 3 shows the prior art multi-chip module disclosed in the Japanese Patent Publication of Unexamined Application.

The component unit 10 comprises a lead-frame 10a, a semiconductor chip 10b mounted on the tub 10c of the lead-frame 10a and a plastic package 10d for sealing the semiconductor chip 10b. The semiconductor chip 10b has pads, and bonding wires 10e and 10f electrically connects the pads to leads 10g and 10h of the lead-frame 10a.

The tub 10c and, accordingly, the semiconductor chip 10b are oblique to the upper surface 10i and the lower surface 10j of the plastic package 10d, and the leads 10g and 10h project from the lower surface 10j and the upper surface 10i, respectively. The lead 10g is twice bent on the lower surface 10j and the upper surface 10i, and forms projections 10k and 10m on the lower and upper surfaces 10j and 10i, respectively.

Similarly, the lead 10h is twice bent on the upper surface 10i and the lower surface 10j, and forms projections 10n and 10o on the upper and lower surfaces 10i and 10j, respectively.

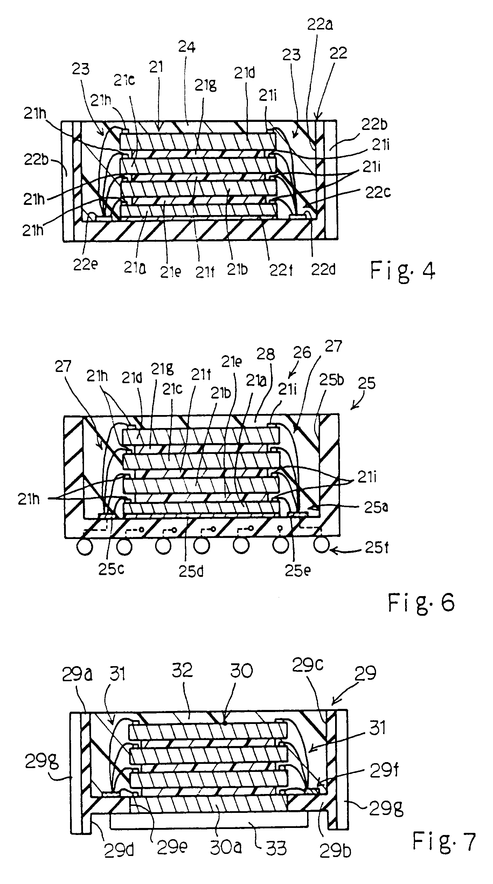

When the component units 10 are stacked as shown in figure 3, the projections 10m/10n of the lower component unit 10 are aligned with the projections 10k/10n of the upper component unit 10, and signals are propagated through the projections 10k/10m/10n/10o between the component units 10.

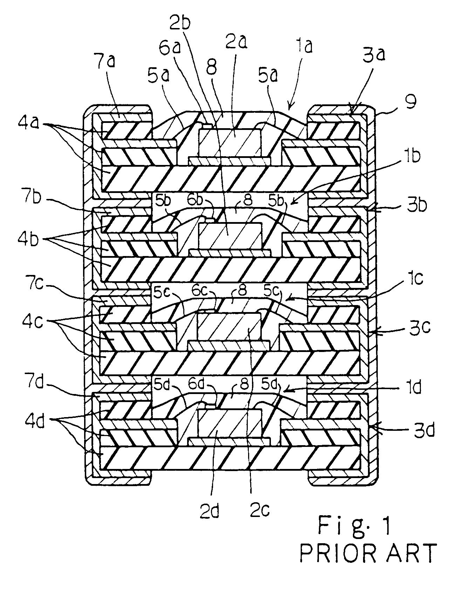

The first prior art three-dimensional multi-chip module encounter a problem in the total thickness. As shown in figure 1, the chip carrier 3a/3b/3c is inserted between the two semiconductor chips 2a/2b, 2b/2c or 2c/2d, and the chip carriers 3a to 3d are thicker than the semiconductor chips 2a to 2d. The chip carriers 3a to 3d are simply stacked on one another, and the first prior art three-dimensional multi-chip module is more than four times thicker than the chip carrier 3a/3b/3c/3d. For this reason, the first prior art three-dimensional multi-chip module is much thicker than the total of the four semiconductor chips 2a to 2d, and the thick module sets a limit on the packaging density on a board.

The second prior art three-dimensional multi-chip module also encounters the problem. Although the oblique lead-frame 10a decreases the area on a board occupied by the second prior art three-dimensional multi-chip module, the plastic package 10d becomes much thicker than the semiconductor chip 10b, and the second prior art three-dimensional multi-chip module is much thicker than the total of the semiconductor chips 10b.

It is therefore an important object of the present invention to provide a three-dimensional multi-chip module which is thin enough to increase the packaging density on a board.

To accomplish the object, the present invention proposes to directly stack semiconductor chips with one another.

To accomplish the object, the present inventor further proposes to remove a reverse surface portion of a semiconductor chip after assemblage with a carrier.

In accordance with one aspect of the present invention, there is provided a three-dimensional multi-chip module comprising: an insulating carrier including a major surface, an outer surface and conductive means exposed to the major surface and the outer surface; a stacked semiconductor chip structure supported by said insulating carrier, and including a plurality of semiconductor chips each having an integrated circuit and conductive pads formed in a peripheral area thereof and electrically connected to the integrated circuit and at least one insulating adhesive compound layer inserted between a central area of one of the plurality of semiconductor chips and a central area of another of the plurality of semiconductor chips; and conductive wires connected between the conductive pads of the plurality of semiconductor chips and the conductive means of the insulating carrier.

In accordance with another aspect of the present invention, there is provided a three-dimensional multi-chip module comprising: a plurality of insulating carrier members laminated on each other, each of the plurality of insulating carrier members having a first inner surface, a second inner surface defining an opening, an outer surface and conductive means exposed to the first inner surface and the outer surface; a plurality of semiconductor chips each accommodated in the opening, each of the plurality of semiconductor chips having conductive pads formed on a first surface portion, an integrated circuit formed in the first surface portion and a second surface portion removed therefrom; and a plurality of sets of conductive wires each connected between the conductive pads of each of the plurality of semiconductor chips and the conductive means of one of the plurality of insulating carrier members.

In accordance with yet another aspect of the present invention, there is provided a process of fabricating a three-dimensional multi-chip module, comprising the steps of: a) preparing an insulating carrier including a major surface, an outer surface and conductive means exposed to the major surface and the outer surface; b) mounting a semiconductor chip on the insulating carrier, the semiconductor chip having a central area, a peripheral area around the central area and conductive pads electrically connected to an integrated circuit and exposed to the peripheral area; c) connecting the conductive pads to the conductive means through conductive wires; d) coating the central area with an adhesive compound layer; e) placing another semiconductor chip on the adhesive compound layer, another semi conductor chip having a central area, a peripheral area around the central area and conductive pads exposed to the peripheral area; and f) connecting the conductive pads of the another semiconductor chip to the conductive means through conductive wires; and g) repeating the steps d), e) and f), if necessary.

In accordance with still another aspect of the present invention, there is provided a process of fabricating a three-dimensional multi-chip module, comprising the steps of: a) preparing a plurality of insulating carrier members each having a first inner surface, a second inner surface defining an opening, an outer surface and conductive means exposed to the first inner surface and the outer surface; b) accommodating each of semiconductor chips in the opening of one of the plurality of insulating carrier members, each of the plurality of semiconductor chips having conductive pads formed on a first surface portion thereof received in the opening and a second surface portion projecting from the opening; c) connecting the conductive pads of each of the plurality of semiconductor chips to the conductive means of one of the plurality of insulating carrier members through conductive wires; d) removing the second surface portion of the aforesaid each of the plurality of semiconductor chips so as to perfectly accommodate the aforesaid each of the plurality of semiconductor chips in the cavity of the aforesaid one of the plurality of insulating carrier member; and e) stacking the plurality of insulating carrier members in such a manner that the conductive means of one of the plurality of insulating carrier members are electrically connected to the conductive means of another of the plurality of insulating carrier members.

The features and advantages of the three-dimensional multi-chip module according to the present invention will be more clearly understood from the following description taken in conjunction with the accompanying drawings in which:
Fig. 1 is a cross sectional view showing the structure of the first prior art stacked multi-chip module;

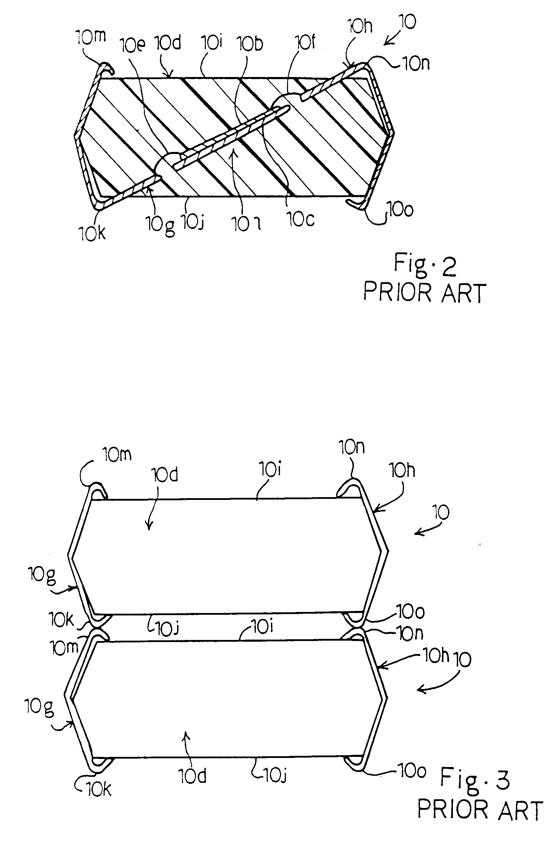

Fig. 2 is a cross sectional view showing the structure of the prior art component unit;
Fig. 3 is a side view showing the second prior art stacked multi-chip module;
Fig. 4 is a cross sectional view showing the structure of a three-dimensional multi-chip module according to the present invention;
Figs. 5A to 5E are cross sectional views showing a process sequence for fabricating the three-dimensional multi-chip module shown in figure 4 and according to the present invention;
Fig. 6 is a cross sectional view showing a first modification of the three-dimensional multi-chip module;
Fig. 7 is a cross sectional view showing a second modification of the three-dimensional multi-chip module;
Fig. 8 is a cross sectional view showing the structure of another three-dimensional multi-chip module according to the present invention;
Figs. 9A to 9E are cross sectional views showing a process sequence for fabricating the three-dimensional multi-chip module according to the present invention;
Fig. 10 is a cross sectional view showing a modification of an insulating carrier member;
Fig. 11 is a side view showing the structure of a three-dimensional multi-chip module using the insulating carrier member;
Fig. 12 is a plan view showing an insulating carrier member for accommodating a plurality of semiconductor chips;
Figs. 13A to 13H are cross sectional views showing a process sequence for fabricating a three-dimensional multi-chip module according to the present invention; and
Fig. 14 is a plan view showing a separation stage of the process sequence illustrated in figures 13A to 13H.

### First Embodiment

Referring to figure 4 of the drawings, a three-dimensional multi-chip module embodying the present invention largely comprises a stacked semiconductor chip structure 21, an insulating carrier 22, bonding wires 23 and synthetic resin 24. The stacked semiconductor chip structure 21 includes four semiconductor chips 21a, 21b, 21c and 21d and insulating adhesive compound layers 21e, 21f and 21g inserted between the semiconductor chips 21a to 21d. An integrated circuit is fabricated on each of the semiconductor chips 21a to 21d, and arrays of pads 21h/21i are formed in the peripheral areas of the upper surfaces of the semiconductor chips 21a to 21d. High-purity organic compound or high-purity inorganic compound forms the insulating adhesive compound layers 21e to 21g. Epoxy resin and Alumina are available for the insulating adhesive compound layers 21e to 21g.

In this instance, the semiconductor chip 21a/21b/21c/ 21d ranges from 100 micron thick to 200 micron thick, and the insulating adhesive compound layer 21e/21f/21g falls within the range between 25 micron thick to 100 micron thick. The stacked semiconductor chip structure 21 is 1.0 to 1.5 millimeters in thickness.

A cavity 22a is formed in the insulating carrier 22, and conductive through-holes 22b are formed on the end surfaces of the insulating carrier 22. The depth of the cavity 22a is equal to or greater than the height of the stacked semiconductor chip structure 21. A conductive pattern 22c is further formed on the bottom surface of the insulating carrier 22, and contains conductive strips 22d, 22e and 22f. The conductive strips are selectively connected to the conductive through-holes 22b.

The stacked semiconductor chip structure 21 is accommodated in the cavity 22a, and the semiconductor chip 21a is fixed to the conductive strip 22f.

The bonding wires 23 are formed of gold, and are 25 microns in diameter. The arrays of pads 21h and 21i are connected through the bonding wires 23 to the conductive pattern 22c. In this instance, the semiconductor chips 21a to 21d have respective integrated circuits identical with one another, and the arrangement of pads 21h/21i is identical between the semiconductor chips 21a to 21d. For this reason, the pads 21h are connected through the respective bonding wires 23 to the conductive strip 22e, and the pads 21i are also connected through the respective bonding wires 23 to the conductive strip 22e.

The synthetic resin 24 fills the cavity 22a, and the stacked semiconductor chip structure 21, the conductive pattern 22c and the bonding wires 23 are hermetically sealed in the synthetic resin 24. In this instance, the synthetic resin is exopy.

Thus, the insulating carrier 22 with the cavity 22a is desirable for the stacked multi-chip module, because the synthetic resin 24 fixes the bonding wires 23. However, the stacked semiconductor chip structure 21 may be mounted on an insulating carrier without a cavity.

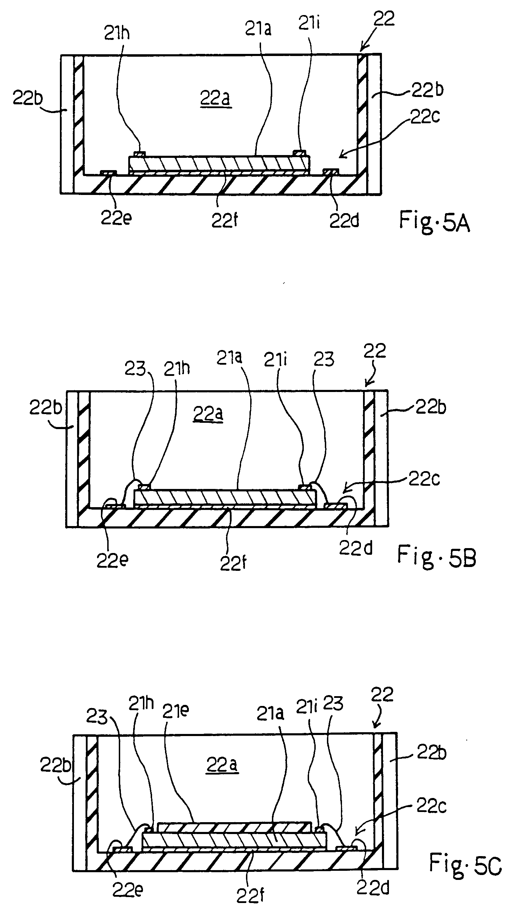

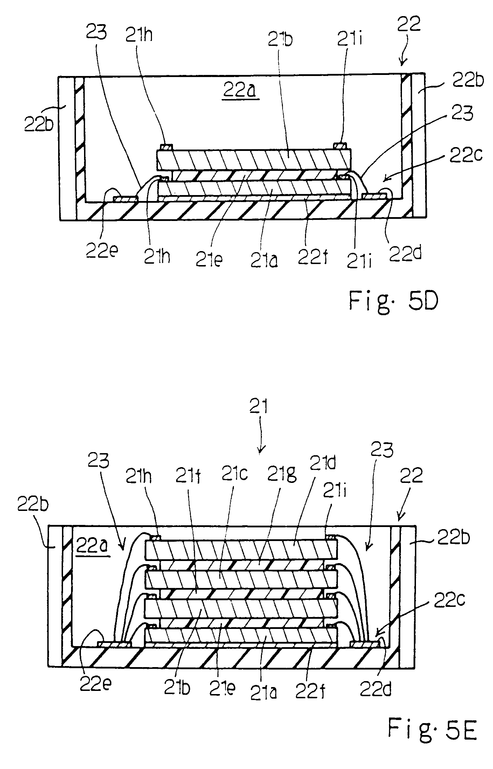

Description is hereinbelow made on a process of fabricating the stacked multi-chip module embodying the present invention with reference to figures 5A to 5E. The process sequence starts with preparation of the insulating carrier 22. The lowest semiconductor chip 21a is mounted on the conductive strip 22f, and is fixed thereto as shown in figure 5A.

Subsequently, the pads 21h/21i are electrically connected through the bonding wires 23 to the conductive strips such as 22d/22e of the conductive pattern 22c as shown in figure 5B.

The central area of the top surface of the semiconductor chip 21a is coated with the insulating adhesive compound, and is overlain by the insulating adhesive compound layer 21e. The semiconductor chip 21b is placed on the insulating adhesive compound layer 21e, and the insulating adhesive compound layer 21e fixes the semiconductor chip 21b to the lowest semiconductor chip 21a as shown in figure 5D.

The wire-bonding, the coating with the insulating adhesive compound layer and the stacking with the semiconductor chip are repeated so as to complete the stacked semiconductor chip structure 21 in the cavity 22a.

Finally, the insulating synthetic resin fills the cavity 22a, and the stacked semiconductor chip structure 21, the conductive pattern 22c and the bonding wires 23 are hermetically sealed in the insulating synthetic resin 24 as shown in figure 4.

In this instance, the conductive pattern 22c and the through-holes 22b as a whole constitute conductive means.

The depth of the cavity 22a is slightly larger than the height of the stacked semiconductor chip structure 21, and the three-dimensional multi-chip module according to the present invention is thinner than the first and second prior art three-dimensional multi-chip modules. For this reason, the three-dimensional multi-chip module according to the present invention is integrated on a mother board at high packaging density.

Moreover, the repetition of the stacking with the semiconductor chip 21a to 21d, the wire-bonding and the coating with the adhesive compound 21e to 21g results in the stacked semiconductor chip structure 21, and the fabrication process is extremely simple. The simple fabrication process decreases the production cost, and increases the production yield.

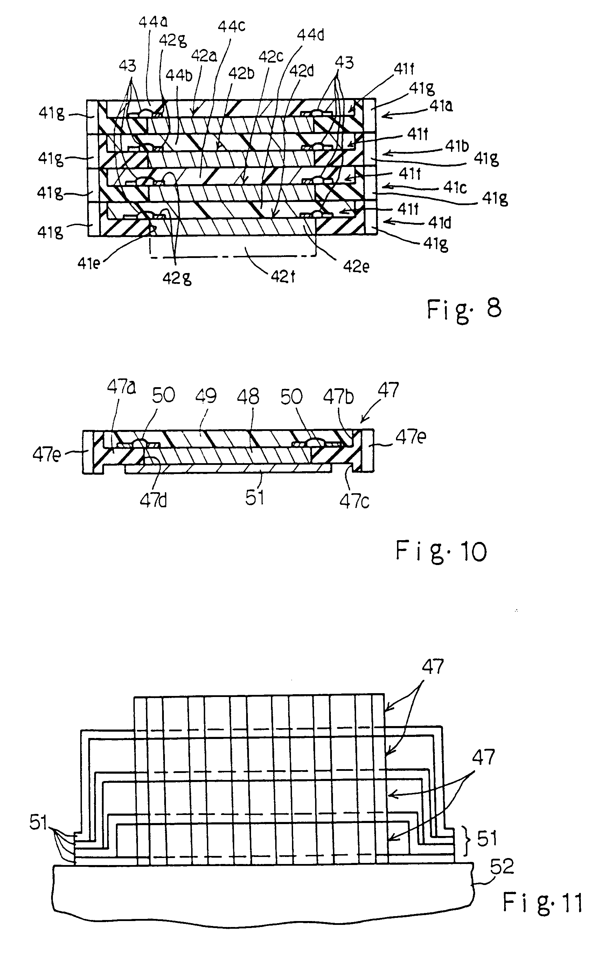

Figure 6 illustrates the first modification of the three-dimensional multi-chip module according to the present invention. Although an insulating carrier 25 is different from the insulating carrier 22, a stacked semiconductor chip structure 26 of the first modification is identical with the stacked semiconductor chip structure 21, and the component layers are labeled with the same references as the corresponding layers of the stacked semiconductor chip structure 21.

The insulating carrier 25 includes a conductive pattern 25a formed on a bottom surface defining a cavity 25b together with an inner side surface, and conductive strips 25c, 25d and 25e form parts of the conductive pattern 25a. The pad arrays are connected to the conductive strips of the pattern 25a through bonding wires 27, and the conductive pattern 25a, the stacked semiconductor chip structure 26 and the bonding wires 27 are sealed in synthetic resin 28.

The insulating carrier 25 further includes a ball grid array 25f formed on the reverse surface of the insulating carrier 25, and the solder balls of the grid array 25f are selectively connected to the conductive strips of the pattern 25a. The conductive pattern 25a and the ball grid array 25f as a whole constitute conductive means. The insulating carrier 25 is mounted on a mother board (not shown), and the ball grid array 25f provides a large number of signal paths to the semiconductor chips 21a to 21d.

If through-holes electrically connected to the ball grid array 25f are further formed on the side surfaces of the insulating carrier 25, the insulating carrier 22 is laminated on the insulating carrier 25, and signals are supplied through the through-holes to the stacked semiconductor chip structure 21 accommodated in the insulating carrier 22. Of course, another insulating carrier 22 may be further laminated on the insulating carrier 22.

Figure 7 illustrates the second modification of the three-dimensional multi-chip module according to the present invention. The second modification also comprises an insulating carrier 29, a stacked semiconductor chip structure 30, bonding wires 31, synthetic resin 32 and a heat sink 33. The stacked semiconductor chip structure 30, the bonding wires 31 and the synthetic resin 32 are similar to those of the first embodiment, and description is focused on the insulating carrier 29 and the heat sink 33 only.

The insulating carrier 29 includes a side wall member 29a and a partition wall member 29b, and the side wall member 29a and the partition wall member 29b define an upper cavity 29c and a lower cavity 29d. An aperture 29e is formed in the partition wall member 29b, and is slightly wider than the lowest semiconductor chip 30a.

The insulating carrier 29 further includes a conductive pattern 29f selectively connected to the pads of the semiconductor chips, and the conductive pattern 29f forms conductive means together with through-holes 29g.

The lowest semiconductor chip 30a is placed in the aperture 29e, and the heat sink 33 is attached to the reverse surface of the lowest semiconductor chip 30a. The insulating carriers 29 may be laminated on one another.

### Second Embodiment

Turning to figure 8 of the drawings, another three-dimensional multi-chip module embodying the present invention largely comprises a plurality of insulating carrier members 41a, 41b, 41c and 41d laminated on one another, a plurality of semiconductor chips 42a, 42b, 42c and 42d supported by the insulating carrier members 41a to 41d, respectively, bonding wires 43 and synthetic resin layers 44a, 44b, 44c and 44d.

The insulating carrier members 41a to 41d are similar in structure to one another, and an insulating side wall and an insulating bottom plate merged with the insulating side wall form a recess 45 in each of the insulating carrier members 41a to 41d. An aperture 41e is formed in the bottom plate, and is slightly wider than the semiconductor chip 42a/42b/42c/42d.

The insulating carrier member 41a to 41d further includes a conductive pattern 41f and conductive through-holes 41g. Conductive strips form the conductive pattern 41f, and are selectively connected to the conductive through-holes 41g.

Each of the semiconductor chips 42a to 42d has an upper surface portion 42e and a lower surface portion 42f. An integrated circuit is formed in the upper surface portion 42e, and conductive pads are formed on the upper surface portion 42e. The upper surface portion 42e is approximately equal in thickness to the insulating bottom plate of the insulating carrier member 41a to 41d, and, accordingly, is received in the aperture 41e. The lower surface portions 42f are removed from the semiconductor chips 42a to 42d after the assemblage of the semiconductor chips 42a to 42d with the insulating carrier members 41a to 41d.

The arrays of pads are connected through the bonding wires 43 to the conductive patterns 41f, respectively, and the semiconductor chips 42a to 42d, the conductive patterns 41f and the bonding wires 43 are sealed in the synthetic resin layer 44a to 44d. The synthetic resin layers 44a to 44d are effective against humidity, and do not allow the bonding wires 43 to be moved or disconnected.

Only an extremely thin surface portion of a semiconductor wafer is consumed in a fabrication process of the integrated circuits, and the remaining portion only imparts the rigidity to the semiconductor wafer. The separation of the semiconductor wafer into the semiconductor chips 42a to 42d and the assemblage with the insulating carrier members 41a to 41d require sufficient rigidity. However, after the assemblage of the semiconductor chips 42a to 42d with the insulating carrier members 41a to 41d, the large rigidity is less important. For this reason, the lower portion 42f is removed from the semiconductor chips 42a to 42d, and only the extremely thin upper surface portions 42e are left in the three-dimensional multi-chip module according to the present invention. The upper surface portion 42e is 0.10 to 0.30 millimeters thick, and makes the total thickness of the module thin.

In this instance, the conductive pattern 41f and the through-holes 41g as a whole constitute conductive means.

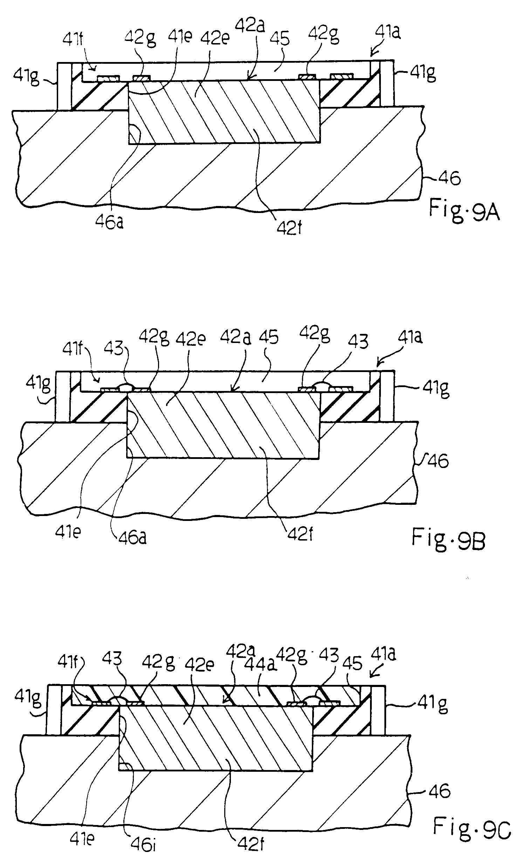

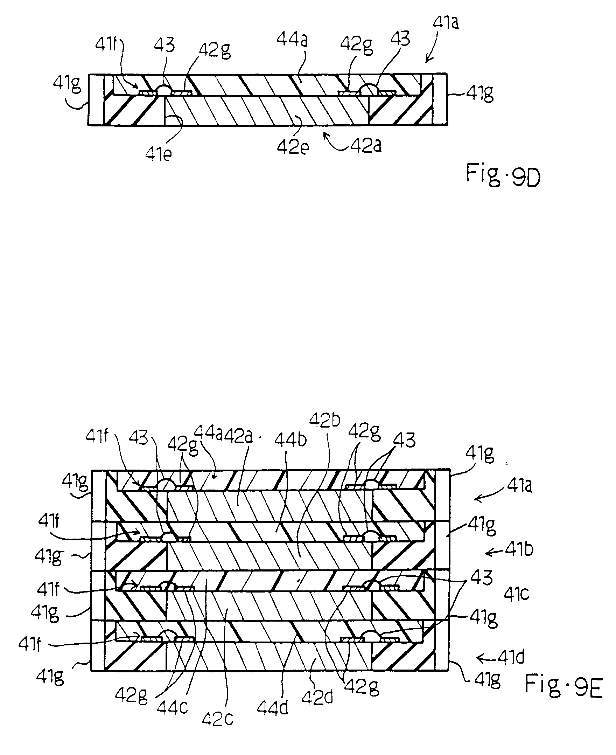

Figures 9A to 9E illustrate a process sequence for fabricating the three-dimensional multi-chip module. First, the insulating carrier member 41a is placed on a work table 46, and the aperture 41e is aligned with a recess 46a formed in the work table 46.

The semiconductor chip 42a is put in the aperture 41e, and the aperture 41e receives the upper surface portion 42e. The recess 46a loosely receives the lower surface portion 42f as shown in figure 9A.

Subsequently, the conductive pads 42g are connected through the bonding wires 43 to the conductive pattern 41f by using a wire-bonding technique as shown in figure 9B.

Synthetic resin liquid fills the recess 45. When the synthetic resin is set, the conductive pattern 41f, the semiconductor chip 42a and the bonding wires 43 are sealed in the synthetic resin layer 44a as shown in figure 9C . The synthetic resin layer 44a fixes the semiconductor chip 42a to the insulating carrier member 41a, and prevents the bonding wires 43 from disconnection. In other words, the lower surface portion 42f becomes less important.

Thus, the semiconductor chip 42a is assembled with the insulating carrier member 41a, and is moved from the work table for removing the lower surface portion 42f.

A grinding machine, a polishing machine, a surface grinder and an etching system are available for removing the lower surface portion 42f, and the reverse surface of the semiconductor chip 42a becomes substantially coplanar with the reverse surface of the insulating bottom plate of the carrier member 41a as shown in figure 9D.

The semiconductor chips 42b to 42d are concurrently or successively assembled with the insulating carrier members 41b to 41d, and the lower surface portions 42f are removed from the semiconductor chips 42b to 42d as similar to the semiconductor chip 42a shown in figure 9D.

The insulating carrier members 41a to 41d are stacked with one another, and metal or conductive resin electrically connects the conductive patterns 41f by using the through-holes 41g as shown in figure 9E. Conductive pins (not shown) may be used for the interconnection.

As described hereinbefore, the upper surface portion 42e ranges 0.10 to 0.30 millimeters thick. When the semiconductor chips 42a to 42d are stacked by means of the insulating carrier members 41a to 41d, the three-dimensional multi-chip module falls between 0.4 millimeters thick to 1.2 millimeters thick. A TSOP (two-sided thin small-outline package) is presently thinnest, and the thickness of TSOP is of the order of 1.0 millimeter. Therefore, the three-dimensional multi-chip module according to the present invention is equivalent in thickness to the TSOP, and the packaging density is four times larger.

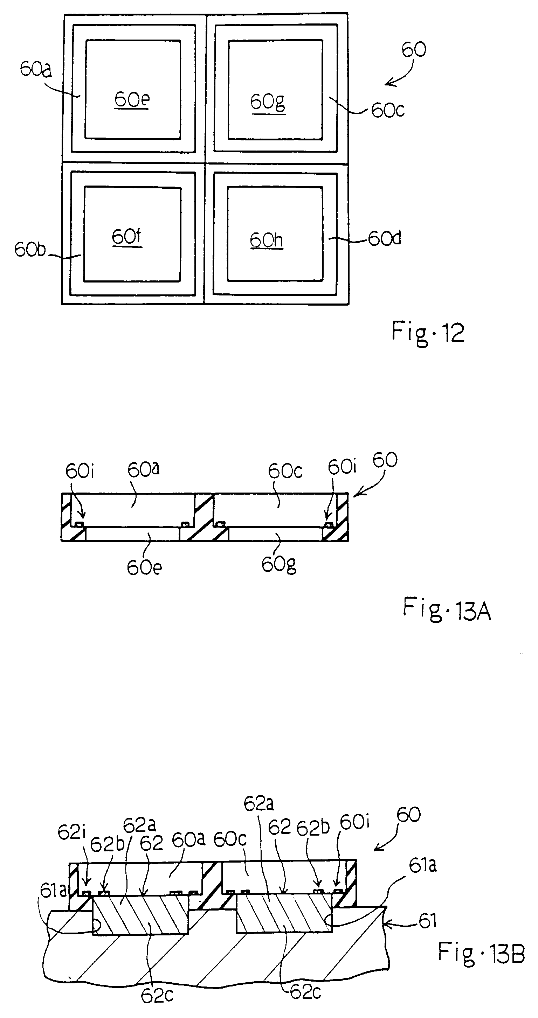

Figure 10 illustrates a modification of the insulating carrier member 41a to 41d assembled with the semiconductor chip 41a to 41d incorporated in a three-dimensional multi-chip module according to the present invention. The modification includes an insulating carrier member 47, and a partition wall 47a defines an upper cavity 47b and a lower cavity 47c. An aperture 47d is formed in the partition wall 47a, and receives a semiconductor chip 48. A lower portion is removed from the semiconductor chip 48 as similar to the semiconductor chips 42a to 42d, and the reverse surface of the semiconductor chip 48 is exposed to the lower cavity 47.

A synthetic resin layer 49 fixes the semiconductor chip 48 to the insulating carrier member 47. Conductive pads of the semiconductor chip 48 are connected through bonding wires 50 to a conductive pattern of the insulating carrier member 47. The conductive pattern is electrically connected to conductive through-holes 47e, and the conductive pattern and the through-holes 47e as a whole constitute conductive means.

A heat sink 51 is attached to the reverse surface of the semiconductor chip 48, and is accommodated in the lower cavity 47c.

When a mother board 52 is stacked with the modifications shown in figure 10, a three-dimensional multi-chip module has heat sinks 1 extending in perpendicular to the paper where figure 11 is illustrated. Though not shown in figure 11, a gap takes place between the synthetic resin layer 49 and the heat sink thereover, and metal or thermo-conductive resin fills the gap. The metal layer or the thermo-conductive resin not only fixes the synthetic resin layer 49 to the heat sink 51 but also radiates the heat to the heat sink 51. The heat sink 51 is attached to the mother board 52, and is shared between the three-dimensional multi-chip module and the mother board 52.

### Third Embodiment

Figures 12, 13A to 13H and 14 illustrate a process of fabricating a three-dimensional multi-chip module embodying the present invention. A composite insulating carrier member 60 has four recesses 60a, 60b, 60c and 60d and four apertures 60e, 60f, 60g and 60h as shown in figure 12, and is equivalent to four insulating carrier members 41a/41b/41c/41d two-dimensionally arranged. The apertures 60e to 60h are slightly wider than semiconductor chips, and semiconductor chips are insertable in the apertures 60e to 60h, respectively.

The fabrication process sequence starts with preparation of the composite insulating carrier member 60, and conductive patterns 60i are formed on the inner surfaces of the composite insulating carrier member 60 as shown in figure 13A. The composite insulating carrier member 60 is placed on a work table 61, and the apertures 60e to 60h are respectively aligned with recesses 61a formed in the work table 61.

The semiconductor chips 62 are respectively put in the apertures 60e to 60h, and upper surface portions 62a of the semiconductor chips 62 are respectively accommodated in the apertures 60e to 60h. Arrays of conductive pads 62b are respectively formed on the upper surfaces of the semiconductor chips 62, and are substantially coplanar with the conductive patterns 60i. The recesses 61a loosely receive the lower surface portions 62c as shown in figure 13B.

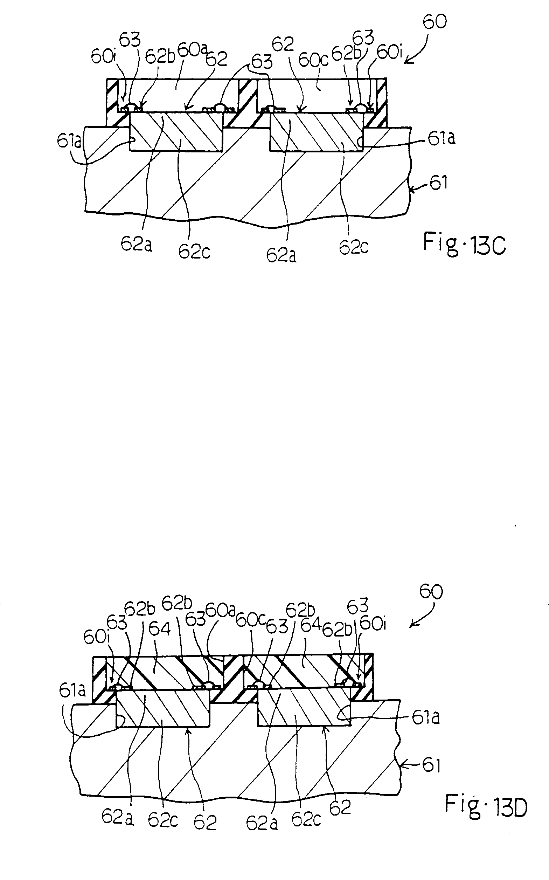

Subsequently, the arrays of conductive pads 62b are connected through the bonding wires 63 to the conductive pattern 61i by using a wire-bonding technique as shown in figure 13C.

Synthetic resin liquid fills the recesses 60a to 60d. When the synthetic resin is set, the conductive patterns 60i, the semiconductor chips 62 and the bonding wires 63 are sealed in the synthetic resin layers 64 as shown in figure 13D. The synthetic resin layers 44a fix the semiconductor chips 62 to the composite insulating carrier member 60, and prevent the bonding wires 63 from disconnection.

Thus, the semiconductor chips 62 are assembled with the composite insulating carrier member 60, and are moved from the work table 61 for removing the lower surface portions 62c.

A grinding machine, a polishing machine, a surface grinder and an etching system are available for removing the lower surface portions 62c, and the reverse surfaces of the semiconductor chips 62 become substantially coplanar with the reverse surface of the insulating bottom plate of the composite insulating carrier member 60 as shown in figure 13E.

If ball grid arrays are necessary on the reverse surfaces of the semiconductor chips 62, the manufacturer concurrently forms the ball grid arrays (not shown) on the reverse surfaces of the semiconductor chips 62 through a solder ball forming process, a solder paste printing process or a dispense process, and the ball grid arrays are regulated to a predetermined height.

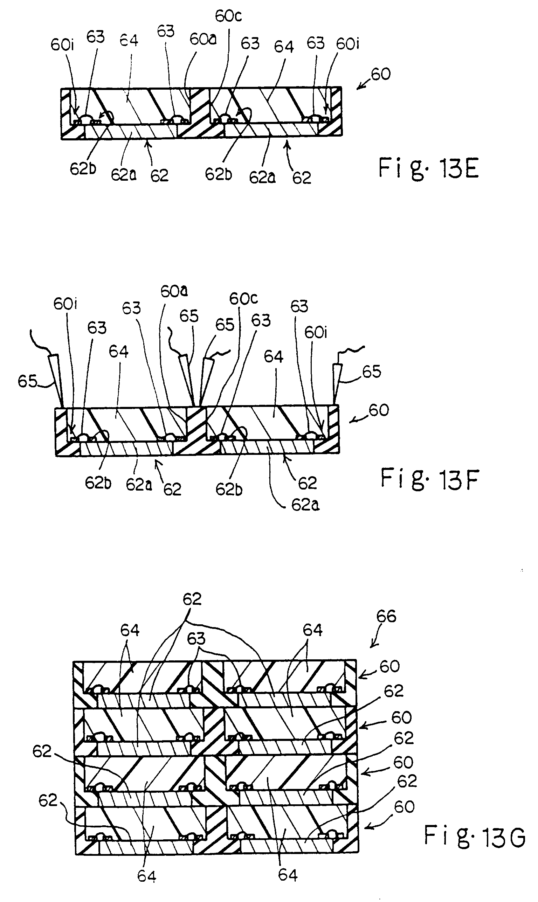

Though not shown in the drawings, the conductive patterns 60i are exposed to the upper surface of the composite insulating carrier member 60, and the manufacturer checks the integrated circuits formed in the semiconductor chips 62 to see whether or not the integrated circuits function without a trouble. In detail, probes 65 are brought into contact with the conductive patterns exposed to the upper surface as shown in figure 13F, and test patterns are supplied from the probes 65 through the conductive patterns to the integrated circuits. The integrated circuits respond to the test patterns so as to produce output signals, and an analyzer (not shown) examines the output signals supplied through the probes 65 so see whether or not the output signals are matched with expected signals. The test is repeated three times, i.e., before a burn-in, during the burn-in and after the burn-in.

In this instance, the integrated circuits are subjected to the test after the removal of the lower portions 62c. However, the test may be carried out after the sealing step.

The composite insulating carrier members 60 are stacked and aligned with one another, and are bonded by using metal or conductive resin. When the metal is used, the metal films inserted between the composite insulating carrier members 60 are reflowed, or the composite insulating carrier members 60 are welded. On the other hand, if the conductive resin is used, the conductive resin layers are thermally or optically set so as to connect the composite insulating carrier members 60 to one another. As a result, a stacked structure 66 is fabricated as shown in figure 13G.

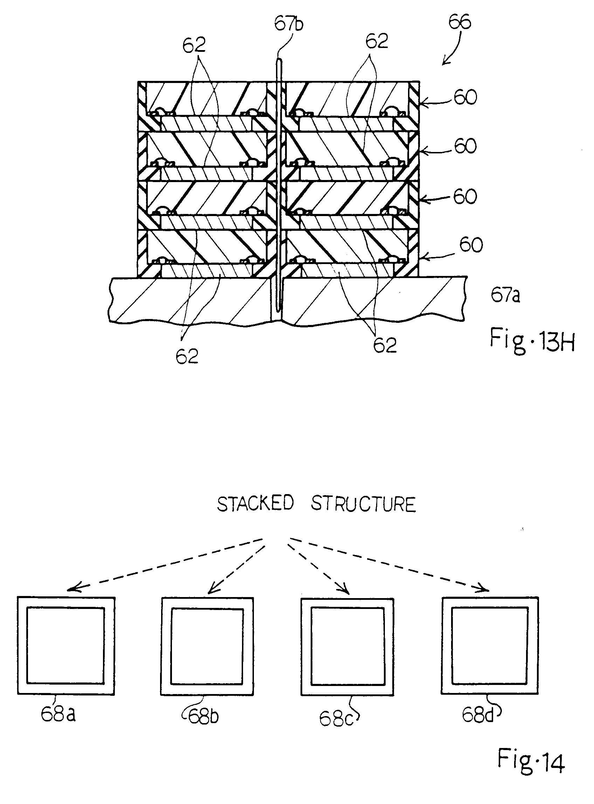

Subsequently, the stacked structure 66 is separated to four three-dimensional multi-chip modules. A dicing machine, a scribing machine or a laser scriber forms separation lines in the stacked structure 66. If the dicing machine is used, the stacked structure 66 is placed on a table 67a, and a blade 67b cuts the stacked structure 66 as shown in figure 13H. If a choco-breaking technique is used, breaking lines are formed in the composite insulating carrier members 60 before the mounting stage shown in figure 13B.

The stacked structure 66 is separated into the four three-dimensional multi-chip modules 68a to 68d as shown in figure 14, and the three-dimensional multi-chip modules 68a to 68d are subjected to the final test, if necessary.

The composite insulating carrier member 60 is desirable for a mass production, and decreases the production cost of the three-dimensional multi-chip module 68a/68b/68c/68d.

Although particular embodiments of the present invention have been shown and described, it will be obvious to those skilled in the art that various changes and modifications may be made without departing from the spirit and scope of the present invention.

For example, different integrated circuits may be formed in the semiconductor chips 21a to 21d or 62. More than or less than four semiconductor chips may be stacked on the insulating carrier. Similarly, more than or less than four insulating carrier members may be stacked so as to fabricate the stacking structure.

The conductive means are not limited to the combination of conductive-pattern/through-holes and the combination of conductive-pattern/ball grid array.

A composite insulating carrier member may be assembled with more than or less than four semiconductor chips.

Finally, more than one insulating carrier 22 may form a composite insulating carrier as similar to the composite insulating carrier member 60.

## Claims

1. A three-dimensional multi-chip module comprising:
an insulating carrier (22; 25; 29) including a major surface, an outer surface and conductive means (22b/22c; 25a/25f; 29f/29g) exposed to said major surface and said outer surface,
characterized by further comprising:
a stacked semiconductor chip structure (21; 26; 30) supported by said insulating carrier (22; 25; 29), and including a plurality of semiconductor chips (21a to 21d) each having an integrated circuit and conductive pads (21h/21i) formed in a peripheral area thereof and electrically connected to said integrated circuit and at least one insulating adhesive compound layer (21e/21f/21g) inserted between a central area of one of said plurality of semiconductor chips and a central area of another of said plurality of semiconductor chips; and
conductive wires (23; 27: 31) connected between said conductive pads of said plurality of semiconductor chips and said conductive means of said insulating carrier.

2. The three-dimensional multi-chip module as set forth in claim 1, further comprising an insulating resin layer covering said conductive pads, said conductive means and said conductive wires.

3. The three-dimensional multi-chip module as set forth in claim 1, in which said major surface defines a cavity (22a; 25b; 29c) where said stacked semiconductor chip structure is accommodated, the depth of said cavity being equal to or greater than the height of said stacked semiconductor chip structure.

4. The three-dimensional multi-chip module as set forth in claim 3, further comprising an insulating resin layer (24; 28; 32) filling said cavity so as to hermetically seal said stacked semiconductor chip structure, said conductive means and said conductive wires therein.

5. The module as set forth in any of claims 1 to 4, in which a conductive pattern (22c; 29f) formed on said major surface and conductive through-holes (22b; 29g) exposed to said outer surface constitute said conductive means.

6. The module as set forth in any of claims. 1 to 4, in which a conductive pattern (25a) formed on said major surface and a ball grid array (25f) constitute said conductive means.

7. The module as set forth in any of claims 1 to 6, further comprising a heat sink (33) attached to one of said plurality of semiconductor chips at the lowest position in said stacked semiconductor chip structure.

8. A three-dimensional multi-chip module comprising an insulating carrier for accommodating semiconductor chips,
characterized in that
said insulating carrier includes a plurality of insulating carrier members (41a-41d; 47) laminated on each other, each of said plurality of insulating carrier members having a first inner surface, a second inner surface defining an opening (41e; 47d), an outer surface and conductive means (41f/41g) exposed to said first inner surface and said outer surface,
said three-dimensional multi-chip module further comprising:
a plurality of semiconductor chips (42a-42d; 48) each accommodated in said opening, each of said plurality of semiconductor chips having conductive pads (42g) formed on a first surface portion (42e), an integrated circuit formed in said first surface portion (42e) and a second surface portion (42f) removed therefrom; and
a plurality of sets of conductive wires (43; 50) each connected between said conductive pads of each of said plurality of semiconductor chips and said conductive means of one of said plurality of insulating carrier members.

9. The three-dimensional multi-chip module as set forth in claim 8, in which said first inner surface defines a cavity to which said opening (41e) is exposed.

10. The three-dimensional multi-chip module as set forth in claim 9, further comprising pieces of resin (44a-44d) each filling said cavity so as to not only hermetically seal said conductive pads, said conductive pattern and the set of conductive wires therein but also fix one of said plurality of semiconductor chips to associated one of said plurality of insulating carrier members.

11. The three-dimensional multi-chip module as set forth in claims 9 or 10, further comprising a plurality of heat sinks (51) respectively attached to said plurality of semiconductor chips.

12. The module as set forth in any of claims 8 to 11, in which a conductive pattern (41f) and conductive through-holes (41g) constitute said conductive means.

13. A process of fabricating a three-dimensional multi-chip module, comprising the steps of:
a) preparing an insulating carrier (22) including a major surface, an outer surface and conductive means (22b/22d/22e) exposed to said major surface and said outer surface;
b) mounting a semiconductor chip (21a) on said insulating carrier, said semiconductor chip having a central area, a peripheral area around said central area and conductive pads (21h/21i) electrically connected to an integrated circuit and exposed to said peripheral area;
c) connecting said conductive pads (21h/21i) to said conductive means (22d/22e) through conductive wires (23);
d) coating said central area with an adhesive compound layer (21e);
e) placing another semiconductor chip (21b) on said adhesive compound layer (21e), said another semiconductor chip having a central area, a peripheral area around said central area and conductive pads (21h/21i) exposed to said peripheral area; and
f) connecting said conductive pads (21h/21i) of said another semiconductor chip to said conductive means (22d/22e) through conductive wires (23); and
g) repeating said steps d), e) and f), if necessary.

14. The process as set forth in claim 13, in which said major surface defines a cavity (22a) where said semiconductor chips (21a-21d) are accommodated, the depth of said cavity being equal to or greater than the total height of the semiconductor chips and said adhesive compound layer or layers.

15. The process as set forth in claim 14, further comprising the step of supplying resin (24) into said cavity (22a) so as to hermetically seal said semiconductor chips (21a-21d), said adhesive compound layer or layers (21e-21g), said conductive means (41f/41g), said conductive pads (42g) and said conductive wires (43) in said resin after said step g).

16. A process of fabricating a three-dimensional multi-chip module, comprising the steps of:
a) preparing a plurality of insulating carrier members (41a-41d) each having a first inner surface, a second inner surface defining an opening (41e), an outer surface and conductive means (41f/41g) exposed to said first inner surface and said outer surface;
b) accommodating each of semiconductor chips (42a-42d) in said opening of one of said plurality of insulating carrier members, each of said plurality of semiconductor chips having conductive pads (42g) formed on a first surface portion (42e) thereof received in said cavity and a second surface portion (42f) projecting from said opening;
c) connecting said conductive pads of each of said plurality of semiconductor chips to said conductive means of one of said plurality of insulating carrier members through conductive wires (43);
d) removing said second surface portion (42f) of said each of said plurality of semiconductor chips so as to perfectly accommodate said each of said plurality of semiconductor chips in said opening of said one of said plurality of insulating carrier member; and
e) stacking said plurality of insulating carrier members (41a-41d) in such a manner that said conductive means of one of said plurality of insulating carrier members are electrically connected to said conductive means of another of said plurality of insulating carrier members.

17. The process as set forth in claim 16, in which said first inner surface defines a cavity (45) to which said opening (41e) is exposed.

18. The process as set forth in claim 17, further comprising the step of filling said cavity with a resin (44a-44d) so as to not only hermetically seal said conductive pads, said conductive means and said conducive wires therein but also fix each of said plurality of semiconductor chips to an associated one of said plurality of insulating carrier members between said step c) and said step d).

19. The process as set forth in claim 16, 17 or 18, in which said second inner surface further defines at least one opening (60e-60h) where another of said plurality of semiconductor chips (62) is accommodated in said step b), said another of said plurality of semiconductor chips (62) being treated as similar to said each of said plurality of semiconductor chips in said steps c) and d),
said process further comprising the steps of separating said plurality of insulating carrier members stacked with one another into a plurality of three-dimensional multi-chip modules.
